# EUROPÄISCHE PATENTSCHRIFT

(11) **EP 1 112 195 B1**
(45) Veröffentlichungstag und Bekanntmachung des Hinweises auf die Patenterteilung: **25.06.2003**
(21) Anmeldenummer: 99969065.4
(22) Anmeldetag: 30.08.1999
(51) Int. Cl.: B60L 3/00, B60L 9/00, G01R 31/00

(54) **ÜBERWACHUNGSVERFAHREN UND ÜBERWACHUNGSVORRICHTUNG FÜR EIN FILTER**
MONITORING METHOD AND MONITORING DEVICE FOR A FILTER
PROCEDE DE SURVEILLANCE ET DISPOSITIF DE SURVEILLANCE POUR UN FILTRE

(30) Priorität: 11.09.1998 DE 19841715
(43) Veröffentlichungstag der Anmeldung: 04.07.2001
(73) Patentinhaber: SIEMENS AKTIENGESELLSCHAFT, 80333 München (DE)
(72) Erfinder: KLÖCKNER, Manfred, D-90409 Nürnberg (DE)
(86) Internationale Anmeldenummer: DE9902705
(87) Internationale Veröffentlichungsnummer: WO00015456

(56) Entgegenhaltungen:
- EP-A- 0 267 548

## Beschreibung

Die vorliegende Erfindung betrifft ein Überwachungsverfahren für ein einer elektrischen Nutzschaltung vorgeordnetes Filter mit mindestens einer Filterkomponente mit einem Filterkennwert sowie eine hiermit korrespondierende Überwachungsvorrichtung.

Aus der EP 0 267 548 A2 ist ein Bahnfahrzeug bekannt, das an einem Gleichspannungsnetz betrieben wird und ein netzseitiges Eingangsfilter besitzt. Das Eingangsfilter besteht hier aus einer Induktivität und einer Kapazität. Der Ausfall einer dieser beiden Komponenten oder gar beider Komponenten hat negative Auswirkungen, insbesondere auf das Störstromverhalten.

Störströme unterliegen oftmals sicherheitsrelevanten Grenzwerten. Somit ist die sichere Funktion des Filters zwingend erforderlich.

Die Aufgabe der vorliegenden Erfindung besteht darin, ein einfaches, zuverlässiges und dennoch kostengünstiges Überwachungsverfahren und eine hiermit korrespondierende Überwachungsvorrichtung zu schaffen, mittels derer eine kontinuierliche Überwachung des Filters möglich ist.

Die Aufgabe wird für das Überwachungsverfahren dadurch gelöst, daß im Betrieb der Nutzschaltung ein zeitlicher Verlauf mindestens eines im Filter fließenden Filterstroms und ein zeitlicher Verlauf mindestens einer im Filter anstehenden Filterspannung erfaßt werden und daß aus den zeitlichen Verläufen der mindestens eine Filterkennwert ermittelt wird.

Hiermit korrespondierend wird die Aufgabe für die Überwachungsvorrichtung dadurch gelöst, daß sie mindestens einen Strommesser zur Erfassung eines zeitlichen Verlaufs mindestens eines im Filter fließenden Filterstroms, mindestens einen Spannungsmesser zur Erfassung eines zeitlichen Verlaufs mindestens einer im Filter anstehenden Filterspannung und eine mit dem mindestens einen Strommesser und dem mindestens einen Spannungsmesser verbundene Auswerteeinheit zur Ermittlung des mindestens einen Filterkennwerts aus den zeitlichen Verläufen aufweist.

Wenn die zeitlichen Verläufe des Filterstroms und/oder der Filterspannung vor der Ermittlung des mindestens einen Filterkennwerts gemittelt werden, sind die Einflüsse von Störungen auf den ermittelten Filterkennwert geringer.

Die Filterkomponente kann eine Drossel mit einer Induktivität oder ein Kondensator mit einer Kapazität sein.

Wenn die Filterkomponente eine Drossel mit einer Induktivität ist, wird die Induktivität als Quotient einer Filterspannung und einer hiermit korrespondierenden Filterstromänderung ermittelt.

In diesem Fall wird die Ermittlung der Induktivität unterdrückt, wenn der Absolutwert der Filterstromänderung einen Filterstromänderungsgrenzwert und/oder der Absolutwert der Filterspannung einen Filterspannungsgrenzwert unterschreitet. Denn dann ist die Induktivität mit einem großen Meßfehler behaftet, so daß keine zuverlässige Aussage über die tatsächliche Induktivität getroffen werden kann.

Wenn hingegen die Filterkomponente ein Kondensator mit einer Kapazität ist, wird die Kapazität als Quotient eines Filterstrom und einer hiermit korrespondierenden Filterspannungsänderung ermittelt.

In diesem Fall wird die Ermittlung der Kapazität unterdrückt, wenn der Absolutwert der Filterspannungsänderung einen Filterspannungsänderungsgrenzwert und/oder der Absolutwert des Filterstroms einen Filterstromgrenzwert unterschreitet. Denn dann ist die Kapazität mit einem großen Meßfehler behaftet, so daß keine zuverlässige Aussage über die tatsächliche Kapazität getroffen werden kann.

Die Filterspannung und/oder der Filterstrom bzw. deren Änderungen können ggf. um ohmsche Anteile korrigiert sein.

Das Überwachungsverfahren wird vorzugsweise bei einem Eingangsfilter einer Stromversorgungseinrichtung eines Schienenfahrzeugs angewendet. Die Nutzschaltung ist also vorzugsweise eine Stromversorgungseinrichtung eines Schienenfahrzeugs.

Weitere Vorteile und Einzelheiten ergeben sich aus der nachfolgenden Beschreibung eines Ausführungsbeispiels. Dabei zeigt die einzige

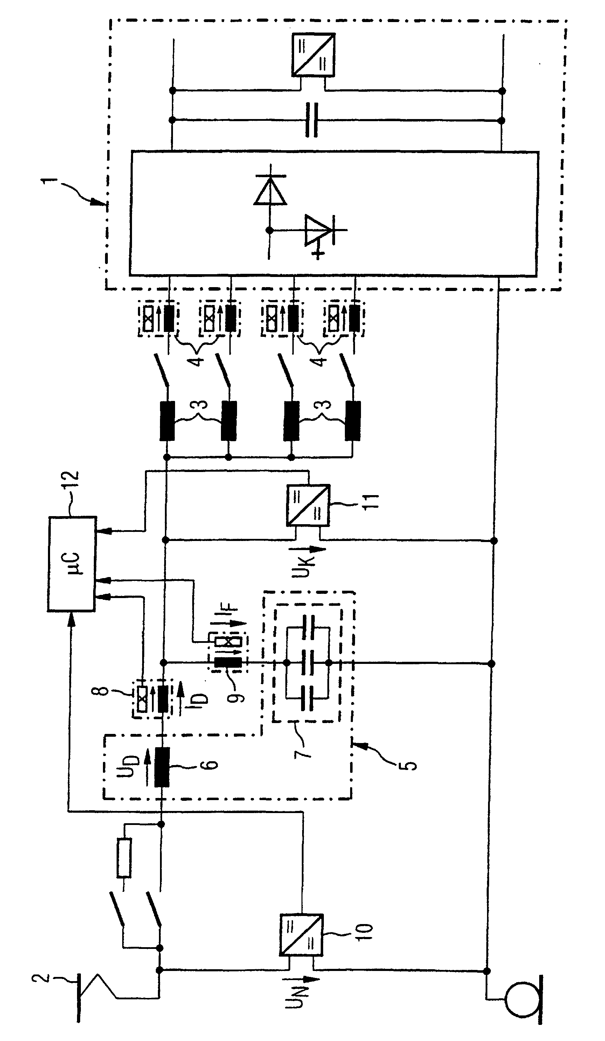

Fig. 1 ein Filter mit einer Überwachungsvorrichtung.

Gemäß Fig. 1 wird eine elektrische Nutzschaltung 1 - dargestellt sind in Fig. 1 lediglich einige Eingangskomponenten der Nutzschaltung 1 - über ein Gleichspannungsnetz 2 mit elektrischer Energie versorgt. Die Nutzschaltung 1 kann beispielsweise die Stromversorgungseinrichtung 1 eines Schienenfahrzeugs bzw. ein Traktionsumrichter des Schienenfahrzeugs sein.

Der Nutzschaltung 1 sind Drosseln 3 nebst zugeordneten Strommessern 4 vorgeordnet. Mittels der Strommesser 4 sind Netzstörungen erfaßbar und ggf. ausregelbar.

Mittels der Strommesser 4 sind die Netzstörungen nur dann erfaßbar, wenn ein vorgeordnetes Filter 5 ordnungsgemäß funktioniert. Das Filter 5 ist also ein Eingangsfilter. Gemäß Fig. 1 besteht das Filter 5 aus zwei Filterkomponenten 6, 7, nämlich einer Drossel 6 und einem Kondensator 7. Die Drossel 6 weist als Filterkennwert eine Induktivität L auf. Der Kondensator 7 weist als Filterkennwert eine Kapazität C auf.

Eine Überwachungsvorrichtung für das Filter 5 weist zwei Strommesser 8, 9 und zwei Spannungsmesser 10, 11 auf. Mit den Strommessern 8, 9 und den Spannungsmessern 10, 11 sind im Betrieb der Nutzschaltung 1 die zeitlichen Verläufe einer Netzspannung U_{N}, einer Kondensatorspannung U_{K}, eines Drosselstroms I_{D} und eines Kondensatorstroms I_{K} erfaßbar. Eine Auswerteeinheit 12 ist mit den Strom- und Spannungsmessern 8 bis 11 verbunden. Die Auswerteeinheit 12 kann z. B. ein Mikrocomputer 12 sein. Die Meßergebnisse der Strommesser 8, 9 und der Spannungsmesser 10, 11 werden laufend an die Auswerteeinheit 12 übermittelt. Diese ermittelt daraus die Induktivität L und die Kapazität C. Dies geschieht wie folgt:

Aufgrund der häufigen Lastwechsel der Nutzschaltung 1 sowie ggf. anderer, an das Gleichspannungsnetz 2 angeschlossener, nicht dargestellter Einheiten ändern sich die von den Strommessern 8, 9 und den Spannungsmessern 10, 11 erfaßten Ströme und Spannungen I_{D}, I_{K}, U_{N}, U_{K} ständig.

Die Induktivität L kann somit als Quotient einer Drosselspannung U_{D} und einer Drosselstromänderung ermittelt werden. Die Drosselspannung U_{D} ergibt sich aus der Differenz von Netzspannung U_{N} und Kondensatorspannung U_{K}. Die Netzspannung U_{N} und die Kondensatorspannung U_{K} können ggf. um einen ohmschen Spannungsabfall korrigiert sein. Die Drosselspannung U_{D} könnte selbstverständlich aber auch direkt gemessen werden. Die Drosselstromänderung ergibt sich als Differenz zweier Messungen des Drosselstroms I_{D}, dividiert durch den zeitlichen Abstand der beiden Messungen. Auch kann der Drosselstrom I_{D} indirekt aus den Meßwerten der Strommesser 4 und 9 ermittelt werden.

In analoger Weise kann die Kapazität C als Quotient des Kondensatorstroms I_{K} und der hiermit korrespondierenden Kondensatorspannungsänderung ermittelt werden. Die Kondensatorspannungsänderung ergibt sich als Differenz zweier Kondensatorspannungen U_{K}, dividiert durch den zeitlichen Abstand der beiden Messungen.

Zur Erhöhung der Meßgenauigkeit können statt der obigen Differentialformen selbstverständlich auch die Integralformen benutzt werden. Die ermittelten Filterkennwerte L,C für die Drossel 6 und den Kondensator 7 liefern ständig eine Information über die Wirksamkeit des Filters 5.

Wenn der Absolutwert der Drosselstromänderung einen Drosselstromänderungsgrenzwert unterschreitet, wird die Berechnung der Induktivität L unterdrückt. Denn in diesem Fall wäre der errechnete Filterkennwert L mit einem zu großen Unsicherheitsfaktor behaftet, um eine zuverlässige Aussage über die tatsächlich wirksame Induktivität zu liefern. Alternativ oder zusätzlich kann die Berechnung der Induktivität L auch dann unterdrückt werden, wenn der Absolutwert der Drosselspannung U_{D} einen Drosselspannungsgrenzwert unterschreitet.

In analoger Weise wird die Berechnung der Kapazität C unterdrückt, wenn der Absolutwert der Kondensatorspannungsänderung einen Kondensatorspannungsänderungsgrenzwert und/oder der Absolutwert des Kondensatorstroms einen Kondensatorstromgrenzwert unterschreitet.

Je nach Ausgestaltung der Überwachungsvorrichtung kann in schneller zeitlicher Folge von jedem der Strom- und Spannungsmesser 8 bis 11 ein Meßsignal eingelesen werden. Beispielsweise kann jede ms ein neuer Meßwert erfaßt werden. Um Störeinflüsse möglichst gering zu halten, können bei schneller Erfassung der Meßwerte mehrere Meßwerte bzw. die zeitlichen Verläufe der erfaßten Ströme I_{D}, I_{K} und Spannungen U_{N}, U_{K} gemittelt werden. Dies kann beispielsweise durch Tiefpaßfilterung oder durch Mittelung einer vorbestimmten Anzahl aufeinanderfolgender Meßwerte (z. B. 3, 5, 10) erfolgen.

Das speisende Netz 2 ist gemäß Ausführungsbeispiel als Gleichspannungsnetz 2 ausgebildet. Das Überwachungsverfahren und die Überwachungsvorrichtung sind prinzipiell aber auch bei Speisung durch ein Wechselspannungsnetz einsetzbar.

Ergänzend sei noch erwähnt, daß selbstverständlich auch die Meßsignale der Strommesser 4 an die Auswerteeinheit 12 übermittelt werden. Somit ist einer der Strommesser 4, 8 und 9 redundant. Er könnte ggf. entfallen und sein Stromwert aus den Meßwerten der anderen Strommesser 4, 8 und 9 errechnet werden.

## Patentansprüche

1. Überwachungsverfahren für ein einer elektrischen Nutzschaltung (1) vorgeordnetes Filter (5) mit mindestens einer Filterkomponente (6,7) mit einem Filterkennwert (C,L), bei dem im Betrieb der Nutzschaltung (1) ein zeitlicher Verlauf mindestens eines im Filter (5) fließenden Filterstroms (I_{D}, I_{K}) und ein zeitlicher Verlauf mindestens einer im Filter anstehenden Filterspannung (U_{K}, U_{N}) erfaßt werden und daß aus den zeitlichen Verläufen der mindestens eine Filterkennwert (C, L) ermittelt wird.

2. Überwachungsverfahren nach Anspruch 1,
**dadurch gekennzeichnet,**
**daß** die zeitlichen Verläufe des Filterstroms (I_{D}, I_{K}) und/oder der Filterspannung (U_{K}, U_{N}) vor der Ermittlung des mindestens einen Filterkennwerts (C,L) gemittelt werden.

3. Überwachungsverfahren nach Anspruch 1 oder 2,
**dadurch gekennzeichnet,**
**daß** die mindestens eine Filterkomponente (6) eine Drossel (6) und der Filterkennwert (L) eine Induktivität (L) ist und daß die Induktivität (L) als Quotient einer Filterspannung (U_{D}) und einer hiermit korrespondierenden Filterstromänderung ermittelt wird.

4. Überwachungsverfahren nach Anspruch 3,
**dadurch gekennzeichnet,**
**daß** die Ermittlung der Induktivität (L) unterdrückt wird, wenn der Absolutwert der Filterstromänderung einen Filterstromänderungsgrenzwert und/oder der Absolutwert der Filterspannung (U_{D}) einen Filterspannungsgrenzwert unterschreitet.

5. Überwachungsverfahren nach Anspruch 1 oder 2,
**dadurch gekennzeichnet,**
**daß** die mindestens eine Filterkomponente (7) ein Kondensator (7) und der Filterkennwert (C) eine Kapazität (C) ist und daß die Kapazität (C) als Quotient eines Filterstroms (I_{K}) einer hiermit korrespondierenden Filterspannungsänderung ermittelt wird.

6. Überwachungsverfahren nach Anspruch 5,
**dadurch gekennzeichnet,**
**daß** die Ermittlung der Kapazität (C) unterdrückt wird, wenn der Absolutwert der Filterspannungsänderung einen Filterspannungsänderungsgrenzwert und/oder der Absolutwert des Filterstroms (I_{K}) einen Filterstromgrenzwert unterschreitet.

7. Überwachungsverfahren nach einem der Ansprüche 1 bis 6,
**dadurch gekennzeichnet,**
**daß** es bei einem Eingangsfilter (5) einer Stromversorgungseinrichtung (1) eines Schienenfahrzeugs angewendet wird.

8. Überwachungsvorrichtung für ein einer elektrischen Nutzschaltung (1) vorgeordnetes Filter (5) mit mindestens einer Filterkomponente (6,7) mit einem Filterkennwert (C,L), die mindestens einen Strommesser (8,9) zur Erfassung eines zeitlichen Verlaufs mindestens eines im Filter (5) fließenden Filterstroms (I_{D}, I_{K}), mindestens einen Spannungsmesser (10,11) zur Erfassung eines zeitlichen Verlaufs mindestens einer im Filter (5) anstehenden Filterspannung (U_{K}, U_{N}) und eine mit dem mindestens einen Strommesser (8,9) und dem mindestens einen Spannungsmesser (10,11) verbundene Auswerteeinheit (12) zur Ermittlung des mindestens einen Filterkennwerts (C, L) aus den zeitlichen Verläufen aufweist.

9. Überwachungsvorrichtung nach Anspruch 8,
**dadurch gekennzeichnet,**
**daß** die Filterkomponente (6) eine Drossel (6) ist.

## Claims

1. Monitoring device for a filter (5) fitted upstream of a usable electrical circuit (1) with at least one filter component (6, 7) with a filter characteristic (C, L), with a time characteristic of at least one filter current (I_{D}, I_{K}) flowing in the filter (5) and a time characteristic of at least one filter voltage (U_{K}, U_{N}) present in the filter being detected during the operation of the usable circuit (1) and at least one filter characteristic (C, L) being determined from the time characteristics.

2. Monitoring device according to Claim 1,
**characterised in that**
the time characteristics of the filter current (I_{D}, I_{K}) and/or of the filter voltage (U_{K}, U_{N}) are averaged before determining at least one filter characteristic (C, L).

3. Monitoring device according to Claim 1 or 2,
**characterised in that**
at least one filter component (6) is a reactor (6) and the filter characteristic value (L) is an inductance (L) and the inductance (L) is determined as a quotient of a filter voltage (U_{D}) and a change in the filter current corresponding to it.

4. Monitoring device according to Claim 3,
**characterised in that**
the determination of the inductance (L) is suppressed if the absolute value of the change in the filter current is less than a filter current change limit value and/or the absolute value of the filter voltage (U_{D}) is less than a filter voltage limit value.

5. Monitoring device according to Claims 1 or 2,
**characterised in that**
at least one filter component (7) is a capacitor (7) and the filter characteristic (C) is a capacitance (C) and that the capacitance (C) is determined as a quotient of a filter current (I_{K}) of a filter voltage change corresponding to it.

6. Monitoring device according to Claim 5,
**characterised in that**
the determination of the capacitance (C) is suppressed if the absolute value of the filter voltage change is less than a filter voltage change limit value and/or the absolute value of the filter current (I_{K}) is less than a filter current limit value.

7. Monitoring device according to Claims 1 to 6,
**characterised in that**
it is used for an input filter (5) of a power supply device (1) of a rail vehicle.

8. Monitoring device for a filter (5) fitted upstream of a usable electrical circuit (1), with at least one filter component (6, 7) with a filter characteristic (C, L), that has at least one ammeter (8, 9) for detecting a time pattern of at least one filter current (I_{D}, I_{K}) flowing in the filter (5), at least one voltmeter (10, 11) for detecting a time pattern of at least one filter voltage (U_{K}, U_{N}) present in the filter (5) and an evaluation unit (12), connected to at least one ammeter (8, 9) and at least one voltmeter (10, 11) for determining at least one filter characteristic (C, L) from the time characteristics.

9. Monitoring device according to Claim 8,
**characterised in that**
the filter component (6) is a reactor (6).

## Revendications

1. Procédé de surveillance pour un filtre (5) monté du côté amont d'un circuit électrique utile (1) et comportant au moins un composant de filtre (6, 7) ayant une valeur caractéristique de filtre (C, L), dans lequel on détecte au cours du fonctionnement du circuit utile (1) une courbe dans le temps d'au moins un courant de filtre (I_{D}, I_{K}) passant dans le filtre (5) et une courbe dans le temps d'au moins une tension de filtre (U_{K}, U_{N}) présente dans le filtre et dans lequel on détermine la ou les valeurs caractéristiques de filtre (C, L) à partir de ces courbes dans le temps..

2. Procédé de surveillance selon la revendication 1,
**caractérisé par le fait qu'**on effectue une moyenne des courbes dans dans le temps du courant de filtre (I_{D}, I_{K}) et/ou de la tension de filtre (U_{K}, U_{N}) avant la détermination de la ou des valeurs caractéristiques (C, L).

3. Procédé de surveillance selon la revendication 1 ou 2,
**caractérisé par le fait que** le composant de filtre (6) est une bobine (6) et la valeur caractéristique de filtre (L) est une inductance (L) et qu'on détermine l'inductance (L) comme quotient d'une tension de filtre (U_{D}) et d'une variation de courant de filtre correspondante.

4. Procédé de surveillance selon la revendication 3,
**caractérisé par le fait qu'**on empêche la détermination de l'inductance (L) lorsque la valeur absolue de la variation de courant de filtre devient inférieure à une valeur limite de variation de courant de filtre et/ou lorsque la valeur absolue de la tension de filtre (U_{D}) devient inférieure à une valeur limite de tension de filtre.

5. Procédé de surveillance selon la revendication 1 ou 2,
**caractérisé par le fait que** le composant de filtre (7) est un condensateur (7) et la valeur caractéristique (C) est une capacité (C) et qu'on détermine la capacité (C) comme quotient d'un courant de filtre (I_{K}) et d'une variation de tension de filtre correspondante.

6. Procédé de surveillance selon la revendication 5,
**caractérisé par le fait qu'**on empêche la détermination de la capacité (C) lorsque la valeur absolue de la variation de tension de filtre devient inférieure à une valeur limite de variation de tension de filtre et/ou lorsque la valeur absolue du courant de filtre (I_{K}) devient inférieure à une valeur limite de courant de filtre.

7. Procédé de surveillance selon l'une des revendications 1 à 6,
**caractérisé par le fait qu'**on l'applique à un filtre d'entrée (5) d'un dispositif d'alimentation en courant (1) d'un véhicule ferroviaire.

8. Dispositif de surveillance pour un filtre (5) monté du côté amont d'un circuit électrique utile (1) et comportant au moins un composant de filtre (6, 7) ayant une valeur caractéristique de filtre (C, L), lequel dispositif de surveillance comporte au moins un dispositif mesureur de courant (8, 9) pour détecter une courbe dans le temps d'au moins un courant de filtre (I_{D}, I_{K}) passant dans le filtre (5), au moins un dispositif mesureur de tension (10, 11) pour détecter une courbe dans le temps d'au moins une tension de filtre (U_{K}, U_{N}) présente dans le filtre (5) et une unité d'évaluation (12) reliée au seul ou aux plusieurs dispositifs mesureurs de courant (8, 9) et au seul ou aux plusieurs dispositifs mesureurs de tension (10, 11) pour déterminer la ou les valeurs caractéristiques de filtre (C, L) à partir de ces courbes dans le temps.

9. Dispositif de surveillance selon la revendication 8,
**caractérisé par le fait que** le composant de filtre (6) est une bobine (6).
